# EUROPEAN PATENT APPLICATION

(11) **EP 1 471 460 A2**
(43) Date of publication of application: **27.10.2004**
(21) Application number: 04009440.1
(22) Date of filing: 21.04.2004
(51) Int. Cl.: G06K 15/12

(54) **Exposure deciding method**

(30) Priority: 22.04.2003 JP 2003117516
(71) Applicant: CANON KABUSHIKI KAISHA, Ohta-ku, Tokyo (JP)
(72) Inventor: Hirabayashi, Jun, Tokyo (JP); Kaburagi, Hiroshi, Tokyo (JP)
(74) Representative: Leson, Thomas Johannes Alois, Dipl.-Ing.

(57) **Abstract**

An image expansion unit (1210) expands image data at a resolution higher than the actual resolution of an output apparatus, and a resolution conversion unit converts the expanded high-resolution data to data having the actual resolution of the output apparatus. An exposure setting unit (1217) outputs a reference pattern and a density sensor measures the density of this reference pattern. On the basis of the result of measurement, a laser-exposure correction table (1213) for an electrophotographic process is created in such a manner that the density of prescribed image data that is obtained by the resolution conversion will be the same before and after image formation. This table is set in a LUT (1213). As a result, it is possible to prevent a situation in which the density and shape of an image are rendered non-uniform and to output a high-quality image in stable fashion.

## Description

### FIELD OF THE INVENTION

This invention relates to a technique for deciding laser exposure when an image is formed by an electrophotographic process.

### BACKGROUND OF THE INVENTION

An image forming apparatus that relies upon electrophotography is used in printers and copiers and finds wide use particularly in business applications. Reproducibility and resolvability of character and line images are strongly demanded in such business applications.

In general, image formation using an electrophotographic process of the kind described below is carried out in an image forming apparatus that relies upon electrophotographic or electrostatic printing.

First, the surface of an image carrier such as an electrophotographic photosensitive body or electrostatic printing dielectric is charged uniformly by a charging member. (This is a charging step.)

Next, light corresponding to an image is shined upon an exposing station and electric charge in the portion exposed to the light is removed, thereby forming an electrostatic latent image that corresponds to the image. (This as a latent-image forming step.)

The electrostatic latent image is developed and converted to a visible image at a developing station. (This is a toner developing step.)

This image is transferred to a transfer medium (transfer step) at a transfer station and is then fixed (fixing step).

Further, in order to control individually the amount of toner particles developed on each area of the image-carrier surface, usually the amount of electric charge in each area is controlled, i.e., the amount of laser exposure of each area is controlled. In order to realize high density locally in an image, the sole method used is to enlarge the amount of laser exposure of the particular area. Further, PWM (pulse-width modulation) or intensity modulation is used to control such laser exposure.

In general, the resolution of an image output device is not always as high as required. When diagonal lines are output, therefore, jaggies may occur. Of course, since resolving power of image output is expressed in units of resolution, the thickness of a line, for example, is increased or decreased in units of the resolution of the image output device. When a fine line, etc., is output, therefore, an output that has been rounded by the resolution of the image output device may be produced rather than the original fine line. As a consequence, the output line may be thicker than the line intended to be output.

Anti-aliasing processing is well known as means for solving this problem, namely how to obtain a smooth image output using a low-resolution image output device.

Anti-aliasing is a technique generally used in image output and usually is implemented using a technique referred to as "over-sampling".
Specifically, after print image data is expanded (over-sampled) at a resolution higher than the actual resolution of the image output device, the high-resolution image data is converted to data having a resolution identical with the actual resolution of the image output device. As a result, the low-resolution image data obtained is output from the image output device.

For example, in case of image output from an image output device having a resolution of 600 dpi, the output image data is expanded at twice the resolution, namely at 1200 dpi, then the data undergoes a resolution conversion to 600 dpi and the 600-dpi image data is finally output from the image output device.

In the event of such anti-aliasing, small values equivalent to the color gray are provided as pixel values for the pixels adjacent black diagonal lines and small dots are thus formed at these adjacent pixels where jaggies would have occurred originally. This makes it possible to output smooth, jaggie-free lines that also have a thickness identical with that originally intended for output.

An actual example of the above will now be described.

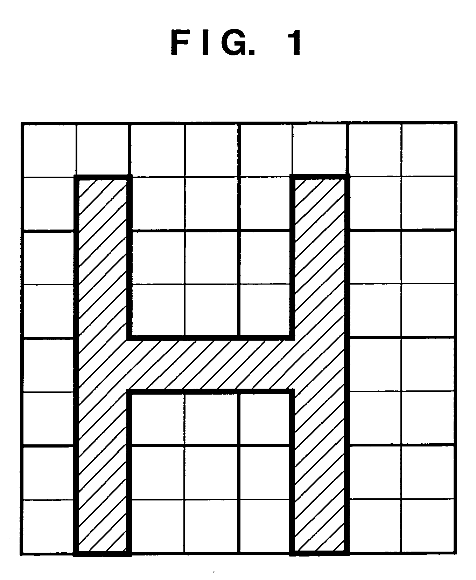

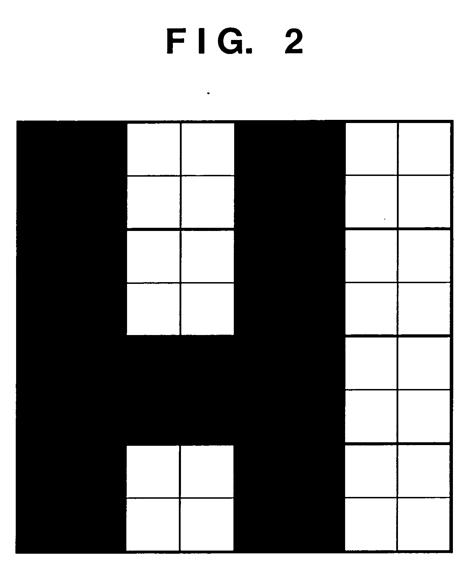

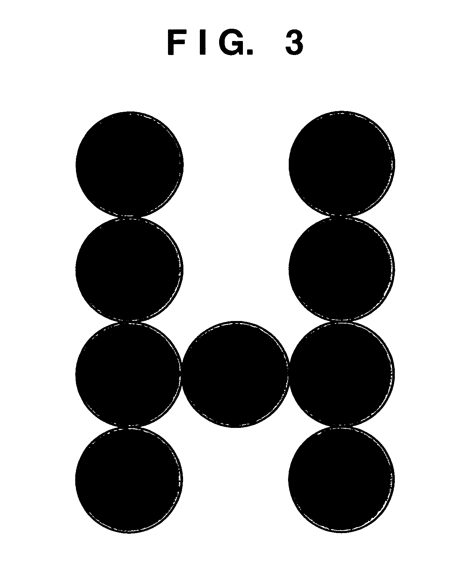

Fig. 1 is a diagram illustrating outline data of the character "H". Fig. 2 is a diagram in which the character "H" shown in Fig. 1 has been expanded at 600 dpi. Fig. 3 is a diagram illustrating an image obtained by outputting the expanded data using an electrophotographic apparatus having a resolution of 600 dpi.

As depicted in Fig. 2, the proportions of the character are altered and the shape of the character changes significantly when the image is expanded at 600 dpi. Line width of the character also becomes greater than originally intended. This detracts from printing quality, as illustrated in Fig. 3.

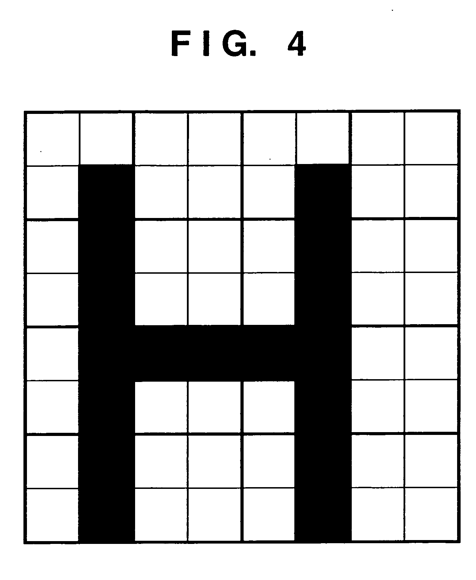

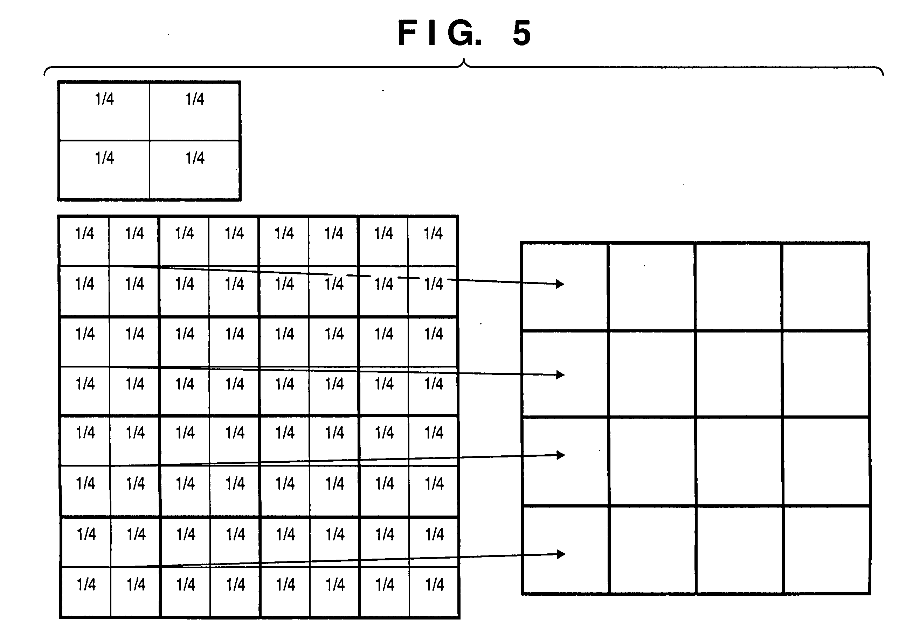

In order to prevent such a decline in image quality, anti-aliasing is applied. Specifically, first the image is expanded using a resolution higher than the output resolution. For example, expansion is performed at a resolution of 1200 dpi, which is higher than the 600-dpi resolution of the image output device, as shown in Fig. 4. In this case there is little degradation of the outline image data shown in Fig. 1. Next, the data that has been expanded at 1200 dpi is converted to half this resolution, namely to 600 dpi (i.e., a resolution equal to the resolution of the image output device). The resolution conversion averages the 1200-dpi data in areas of, e.g., 2 × 2 using a 2 × 2 matrix of the kind shown in Fig. 5, thereby achieving the conversion to 600-dpi data. In the example shown in Fig. 5, each pixel of 1200-dpi data is simply averaged in the 1200-dpi 2 × 2 area (i.e., an area of one dot of 600 dpi) and the pixel value of one dot of 600 dpi is calculated.

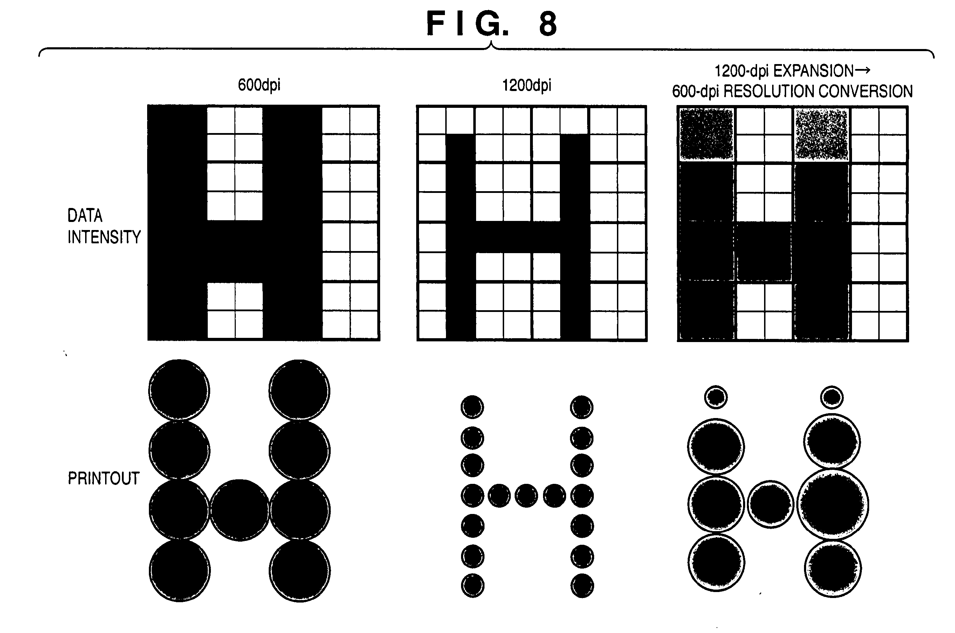

For example, 1200-dpi data shown in Fig. 4 is converted to 600-dpi data of the kind shown in Fig. 6. As a result, a print image output from the image output device is as illustrated in Fig. 7.
Specifically, it will be understood that the loss of proportions and the change in line width that occur at 600 dpi are improved upon in the case of an output using anti-aliasing. Fig. 8 is a diagram illustrating a comparison between 600- and 1200-dpi printouts and a printout that is obtained upon effecting a resolution conversion to 600 dpi following expansion at 1200 dpi.

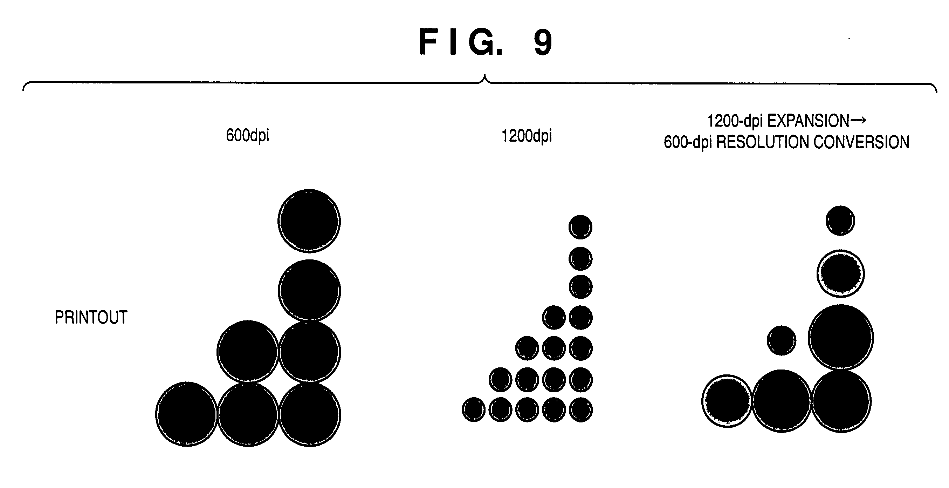

As shown in Fig. 9, anti-aliasing forms small-size dots by outputting half-tones with respect to areas in which jaggies would occur conventionally. This therefore is a very effective method through which it becomes possible to manifest a large jaggies-suppression effect and achieve an output that is faithful to the original image data.

When the conventional anti-aliasing processing described above is applied, however, the following problem arises:

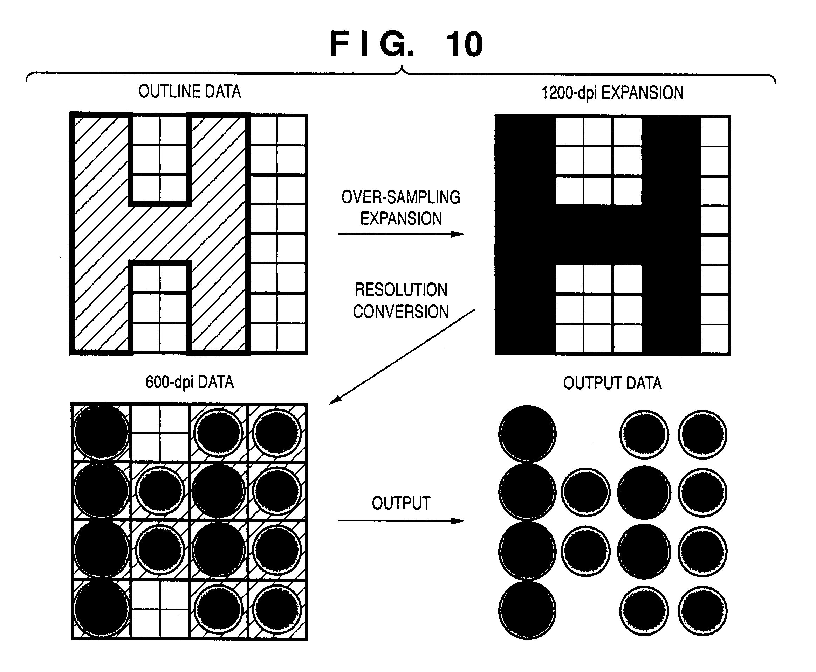

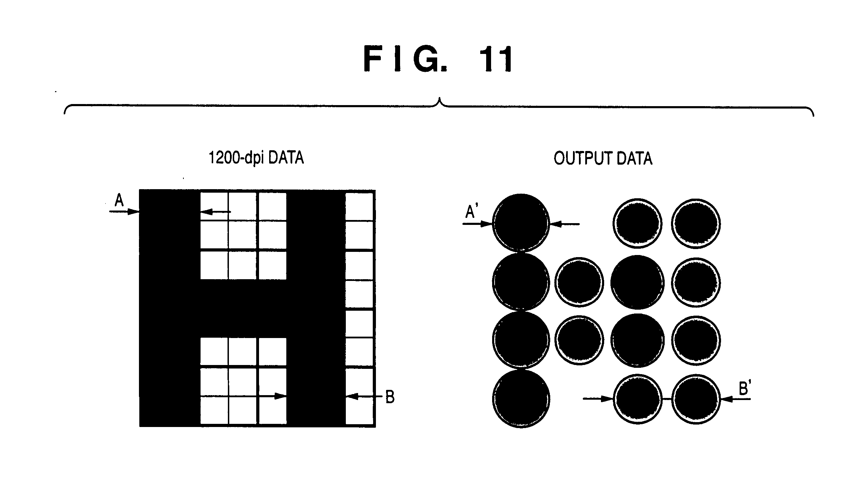

Fig. 10 is a diagram illustrating a process through which an outline font of the character "H" is expanded at 1200 dpi followed by a resolution conversion to 600 dpi and output of the resulting data. Further, Fig. 11 is a diagram illustrating a comparison between 1200-dpi expanded data and 600-dpi output data. In the 1200-dpi expanded data of Fig. 11, the thicknesses of the two vertical lines in the character "H" are entirely the same, as illustrated at A and B. There is no difference at all between A and B. By contrast, in the 600-dpi output data, the two vertical lines A' and B' in the character "H" are different.

This is caused depending upon whether or not the line portions fall within the 2 × 2 matrix. Owing to the difference in image formation that arises from the difference in conditions at the time of the resolution conversion, the two vertical lines do not necessarily give the appearance of identical densities to the observer (who is viewing the printed image) and the image that should provide the same thicknesses (densities) originally is output with different thicknesses (densities) unintentionally.

The reason for this problem is as follows: With image data in the stage where it has been over-sampled at a high resolution, an area in which conditions are the same is handled under different conditions in resolution conversion processing when the area is subjected to a resolution conversion and converted to low resolution and, as a result, a conversion is made to different image formation states. Thus, density and shape of an output image is not uniform between areas in which image formation states differ from one another.

### SUMMARY OF THE INVENTION

Accordingly, an object of the present invention is to set appropriately amount of laser exposure based upon an electrophotographic process, thereby preventing non-uniformity of density and shape of an image and performing stable, high-quality image output.

According to the present invention, the foregoing object is attained by providing an exposure deciding method for deciding laser exposure when image formation is performed by an electrophotographic process, comprising: an expansion step of expanding image data at a resolution higher that actual resolution of an output apparatus; a resolution conversion step of subjecting high-resolution data, which is the result of expansion at the expansion step, to a resolution conversion to the actual resolution of the output apparatus; an exposure decision step of deciding laser exposure when image formation is performed in such a manner that density of prescribed image data will be the same before and after image formation; and an image formation step of forming an image represented by image data, which has undergone the resolution conversion performed at the resolution conversion step, based upon the laser exposure that has been decided at the exposure decision step.

Further, according to the present invention, the foregoing object is attained by providing an image forming apparatus for deciding laser exposure when image formation is performed by an electrophotographic process, comprising: expansion means for expanding image data at a resolution higher that actual resolution of an output apparatus; resolution conversion means for subjecting high-resolution data, which is the result of expansion by the expansion means, to a resolution conversion to the actual resolution of the output apparatus; exposure decision means for deciding laser exposure when image formation is performed in such a manner that density of prescribed image data will be the same before and after image formation; and image formation means forming an image represented by image data, which has undergone the resolution conversion performed by the resolution conversion means, based upon the laser exposure that has been decided by the exposure decision means.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

Fig. 1 is a diagram illustrating outline data representing the character "H";
Fig. 2 is a diagram in which the character "H" has been expanded at 600 dpi;
Fig. 3 is a diagram illustrating an image that has been output by an electrophotographic apparatus having an output resolution of 600 dpi;
Fig. 4 is a diagram in which the character "H" has been expanded at 1200 dpi;
Fig. 5 is a diagram in which 1200-dpi data has been converted to 600-dpi data using a 2 × 2 matrix;

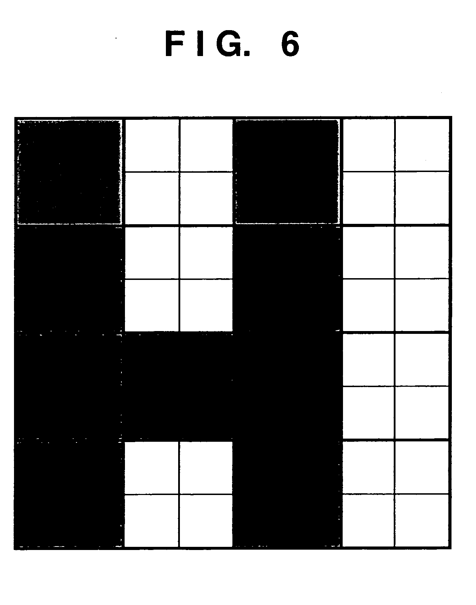

Fig. 6 is a diagram in which the 1200-dpi data shown in Fig. 4 has been converted in terms of resolution to 600-dpi data;

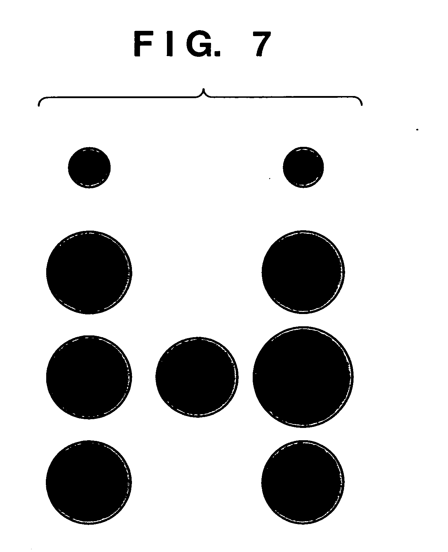

Fig. 7 is a diagram illustrating a printed image obtained by printing the 600-dpi data shown in Fig. 6;
Fig. 8 is a diagram illustrating a comparison between 600- and 1200-dpi printouts and a printout that is obtained upon effecting a resolution conversion to 600 dpi following expansion at 1200 dpi;
Fig. 9 is a diagram illustrating a printout in which the occurrence of jaggies has been reduced;
Fig. 10 is a diagram illustrating a process through which an outline font of the character "H" is expanded at 1200 dpi followed by a resolution conversion to 600 dpi and output of the resulting data;
Fig. 11 is a diagram illustrating a comparison between 1200-dpi expanded data and 600-dpi output data;

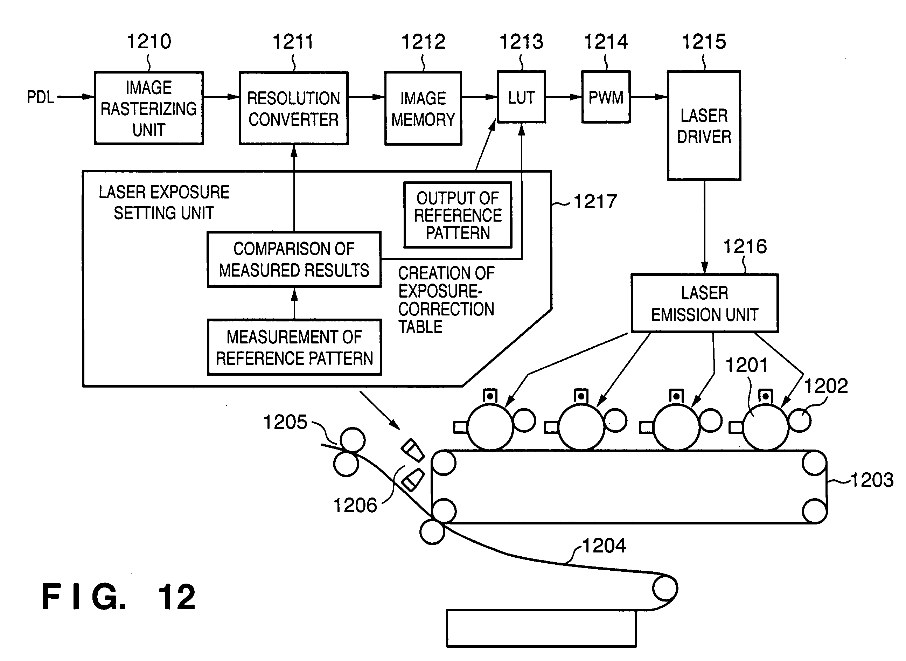

Fig. 12 is a diagram illustrating the structure of an image forming apparatus according to an embodiment of the present invention;

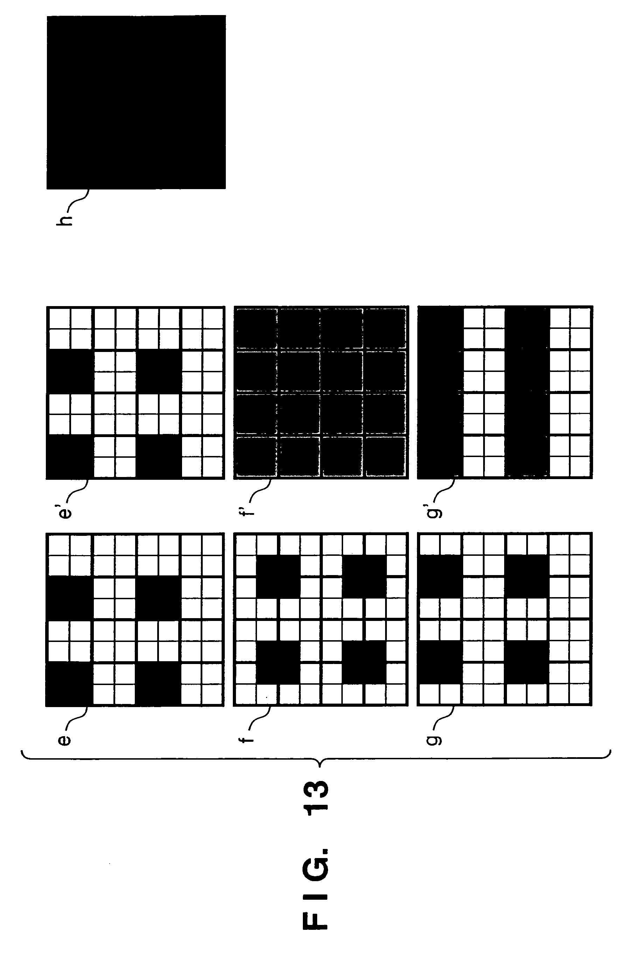

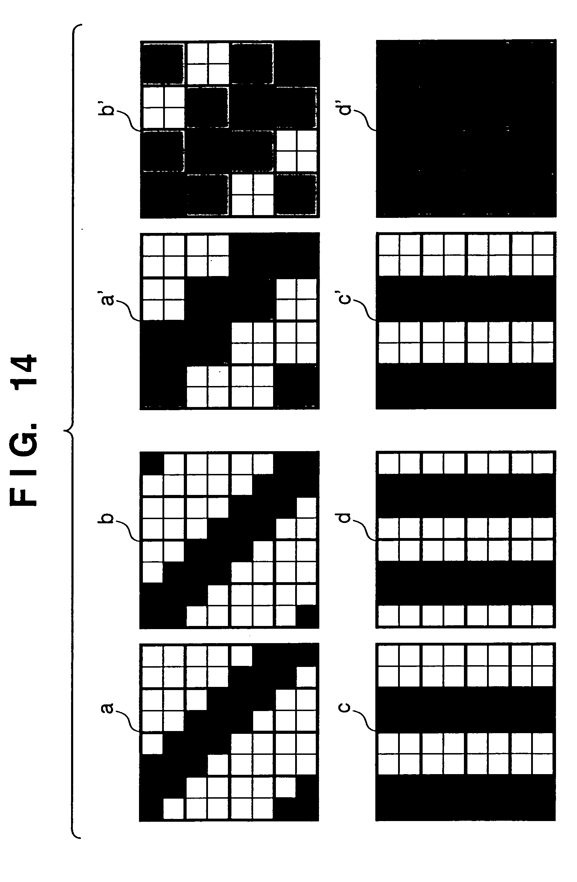

Figs. 13 and 14 are diagrams illustrating seven types of reference patterns and seven types of formed test patches according to a first embodiment of the invention;

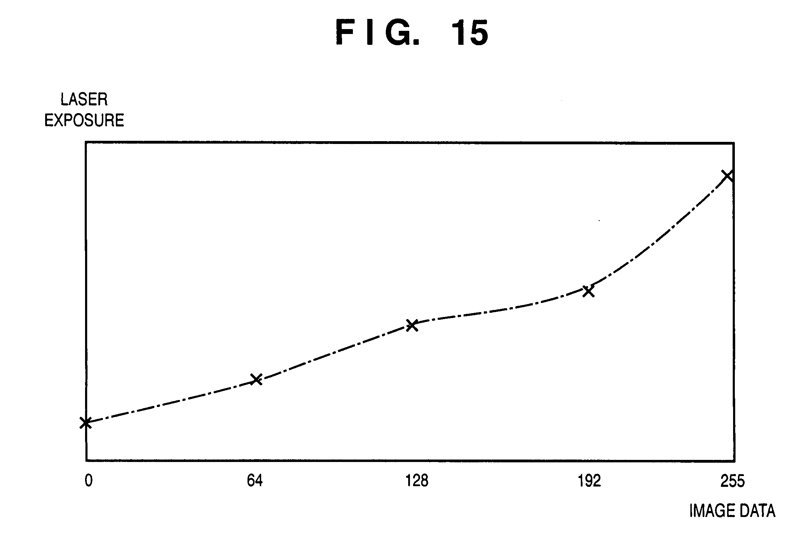

Fig. 15 is a diagram illustrating the relationship between image data and laser exposure (compensation) according to the first embodiment;

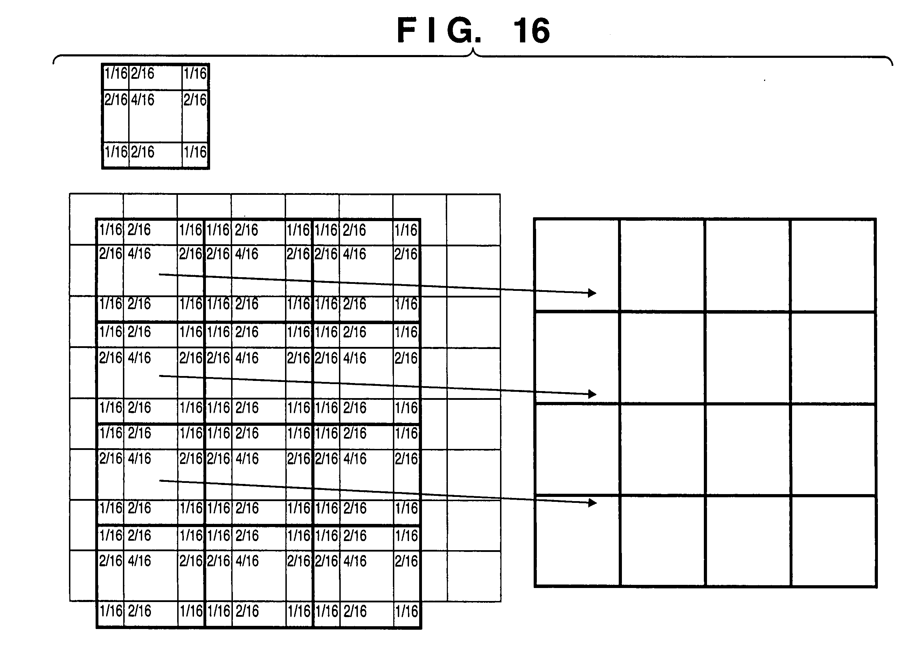

Fig. 16 is a diagram illustrating a matrix used in a resolution conversion according to a second embodiment of the invention;

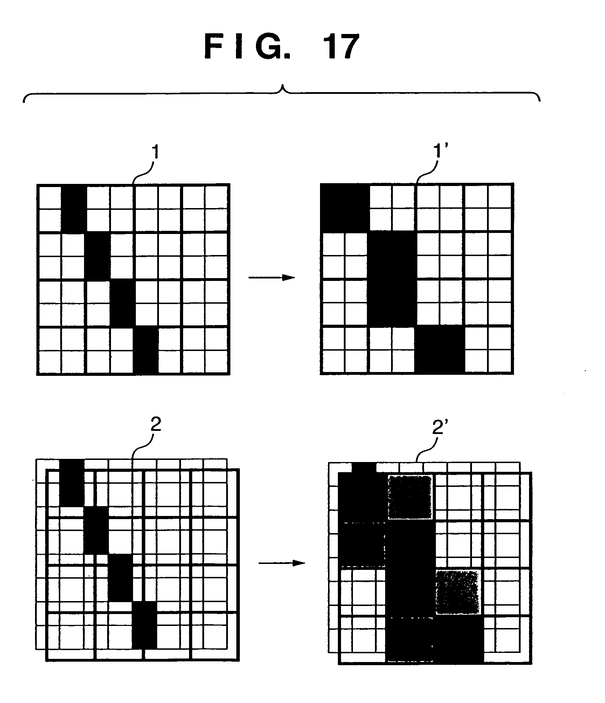

Fig. 17 is a diagram illustrating an example of a resolution conversion according to the second embodiment;

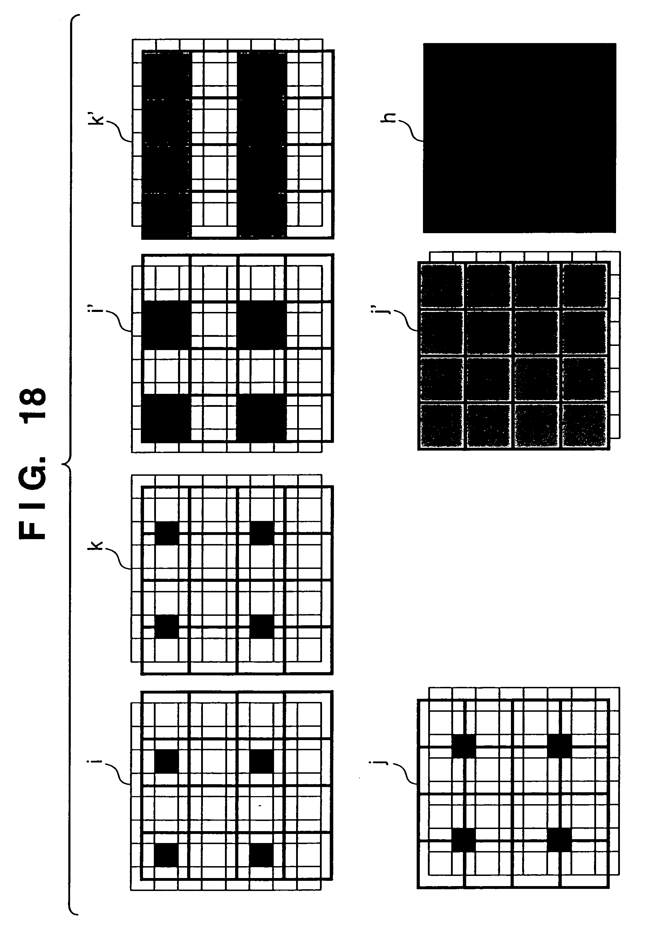

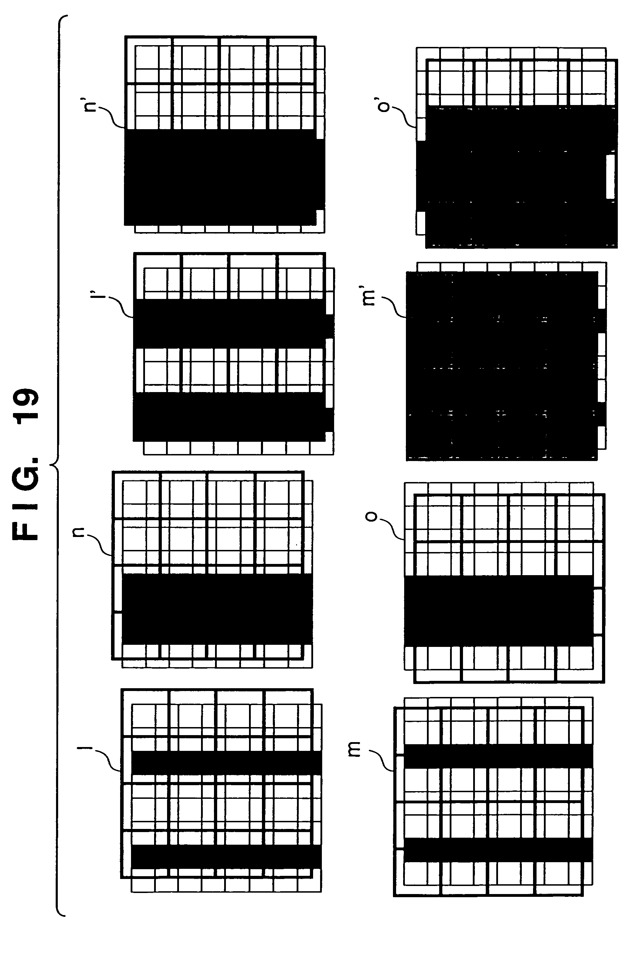

Figs. 18 and 19 are diagrams illustrating eight types of reference patterns and eight types of formed test patches according to a second embodiment of the invention;

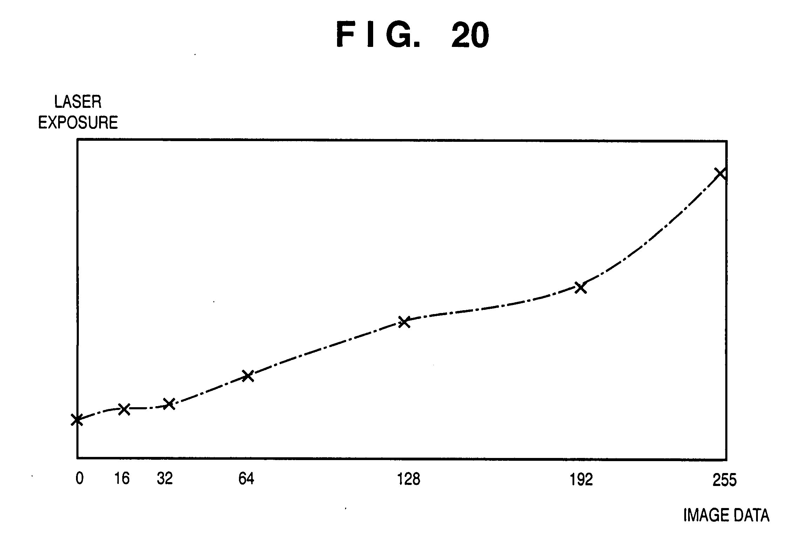

Fig. 20 is a diagram illustrating the relationship between image data and laser exposure (compensation) according to the second embodiment;

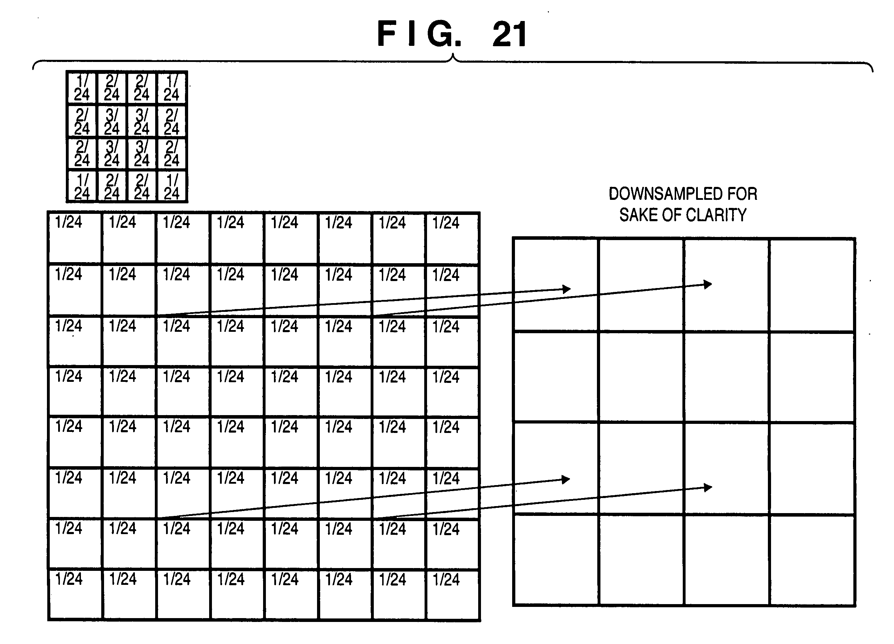

Fig. 21 is a diagram illustrating a matrix used in a resolution conversion according to a third embodiment of the invention;

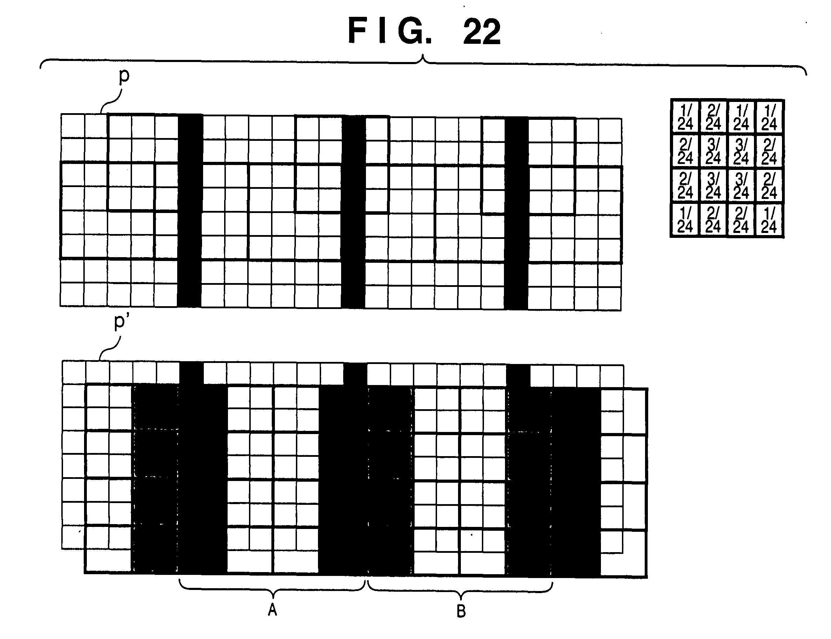

Fig. 22 is a diagram illustrating reference patterns and a formed test patch according to the third embodiment; and

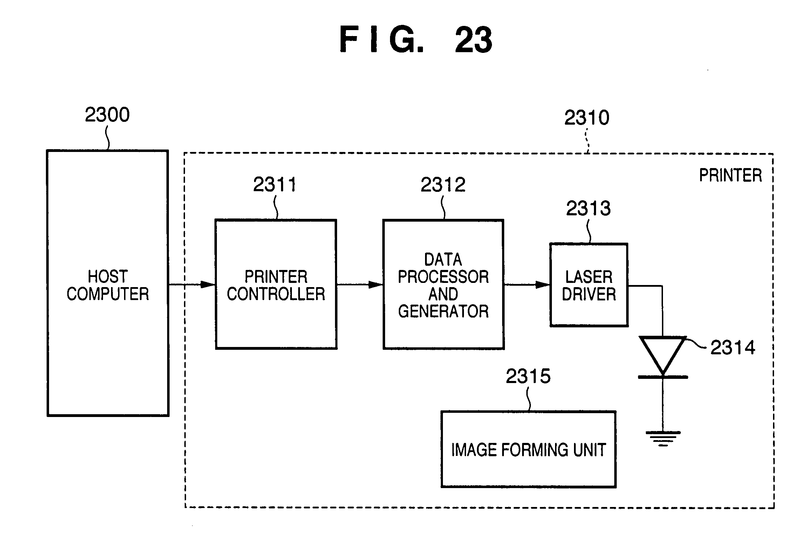

Fig. 23 is a diagram illustrating an example of the structure of an image output apparatus according to this embodiment.

### DETAILED DESCRIPTION OF THE PREFERRED EMBODIMENTS

Preferred embodiments of the present invention will now be described in detail with reference to the drawings.

In the embodiments, an image output apparatus having an actual resolution of 600 dpi for image formation first expands image data at a high resolution of 1200 dpi in an area such as a character or vector image, then converts the 1200-dpi data to 600-dpi data using a 2 × 2 matrix and subjects the 600-dpi data to various conversions (laser-exposure correction, etc.) and outputs the resulting image.

Further, though the layout per se at the original 1200 dpi is the same, the resolution conversion conditions differ. Accordingly, test patches of reference patterns that will result in different image formation states at 600 dpi are formed, the test patches are read at the surface of an intermediate transfer belt, and laser exposures are set in such a manner that these output results will approach one another, as a result of which there is created a laser-exposure correction table used in areas in which a resolution conversion was employed. This is a characterizing feature of the invention.

### <Structure of apparatus>

Fig. 23 is a diagram illustrating the structure of an image output apparatus according to this embodiment. In the example shown in Fig. 23, a laser printer is described as an example of the image output apparatus. However, the present invention is not limited to this arrangement and may also be applied to an electrophotographic copier or facsimile machine.

A host computer 2300 shown in Fig. 23 is a personal computer or the like and specifies printing of a document or image created by a prescribed application. A laser printer 2310 forms images based upon print data, e.g. page description language (PDL) sent from the host computer 2300.

The printer 2300 includes a printer controller 2311 that processes the print data sent from the host computer 2300; a data processor and generator 2312 for performing a resolution conversion and setting of laser exposure, the details of which will be described later; a laser driver 2313 for driving a semiconductor laser 2314 based upon the laser exposure that has been set by the data processor and generator 2312; and an image forming unit 2315 for forming an image in accordance with the laser exposure from the semiconductor laser 2314.

The operation of the laser printer 2310 (referred to as an image forming apparatus in Fig. 12) of this embodiment will now be described in detail with reference to Fig. 12.

Fig. 12 is a diagram illustrating the structure of an image forming apparatus according to this embodiment. As shown in Fig. 12, the image forming apparatus is an electrophotographic image forming apparatus that draws a latent image on the surface of a charged drum 1201 by laser exposure, develops the latent image using toner in a developing unit 1202, transfers the toner image to an intermediate transfer belt 1203, transfers the toner image from the intermediate transfer belt 1203 to transfer paper 1204, thereby forming a printed image, and fixes the printed image in a fixing unit 1205.

### <Image expansion>

PDL that has entered the image forming apparatus from a personal computer is expanded into raster data by an image rasterizing unit 1210. Expansion into the raster image is performed for every type of image and is handled separately according to whether an image is a character/vector image or photographic image, by way of example. Here a character/vector image is expanded at a resolution of 1200 dpi to obtain 1200-dpi raster data.

### <Resolution conversion>

The image data of the character/vector portions expanded at 1200 dpi is converted to a resolution of 600 dpi by averaging a 2 × 2 area using a 2 × 2 matrix [(1/4, 1/4), (1/4, 1/4)], as shown in Fig. 5, in a resolution converter 1211. The image data obtained by the resolution conversion is stored in an image memory 1212, the amount of exposure is decided by a laser-exposure correction table (LUT) 1213, pulse-width modulation is applied by a PWM unit 1214, the modulated data is input to a laser driver 1215, and a laser emission unit 1216 causes lasers to emit light, thereby rendering latent images on corresponding photosensitive drums 1201 and forming print images.

### [First Embodiment]

Described next will be a method of setting laser exposure in a first embodiment in which the image forming apparatus of Fig. 12 forms test patches of reference patterns during a phase of operation in which an image is not being formed (this shall be referred to as "non-image formation" below), reads the test patches and creates the laser-exposure correction table based upon the densities of the test patches read.

### <Reference image formation, reading of reference image and correction of exposure>

First, during the non-image formation phase, seven types of test patches a', b', c', d', e', f', g' and h shown in Figs. 13 and 14 are formed. It should be noted that reference characters a to h shown in Figs. 13 and 14 denote the corresponding reference patterns, in which h represents the reference pattern of a solid image.

The densities of a test patches that have been formed on the intermediate transfer belt 1203 are measured by a density sensor 1206.

The test patches a', b', c' and d' shown in Fig. 14 are the result of applying a resolution conversion to the 1200-dpi line-image data a, b, c, and d, respectively. The reference patterns a and b are originally identical patterns (only the positions differ). Similarly, the reference patterns c and d are originally identical patterns in which only positions differ.

Despite the fact that the patches a' and 'b or c' and d' basically are the same patterns at the time of the expansion at 1200 dpi, they become quite different in the exposure patterns after being subjected to an averaging and reducing process using a 2 × 2 matrix at the time of the resolution conversion to 600 dpi.

Further, the patches e', f' and g' similarly are the result of applying a resolution conversion to 1200-dpi dot image data e, f, g. Here the patterns e, f and g are originally the same dot patterns. However, the image data obtained after the resolution conversion to 600 dpi differs greatly depending upon how the 2 × 2 matrix used to perform averaging at the time of the resolution conversion to 600 dpi is deployed.

Usually, in a case where latent images having different exposure patterns are rendered in electrophotography, the print image densities thereof will differ. In other words, a problem which arises is that despite the fact that line or character images should originally be the same at expansion at 1200 dpi, they become different lines or characters in the printed image that is output after a resolution conversion to 600 dpi.

For example, if one considers a pattern in which a line having the same thickness is rendered repeatedly, the thickness of every other line changes despite the fact that the lines are output at the same thickness. Regardless of the anti-aliasing processing (over-sampling) the original purpose of which is to raise the quality of line and character images, this purpose cannot be attained satisfactorily if the above-described problem arises.

In order to solve the above problem, a laser exposure setting unit 1217 in the first embodiment reads and measures the densities of the seven types of test patches a', b', c', d', e', f', g' and h, which have been formed during non-image formation, on the intermediate transfer belt 1203 by the density sensor 1206, applies a laser exposure correction, creates the laser-exposure correction table in such a manner that the densities of a' and b' or of c' and d' become the same and stores this table in the LUT 1213.

More specifically, a laser-exposure correction table of the kind shown in Fig. 15 is created through the procedure described below. Here the image data is handled as data having 256 levels of 0 to 255.
(1) The test patch h on the intermediate transfer belt 1203 is measured by the density sensor 1206 and a laser exposure corresponding to image data 255 that provides the highest density is set to an exposure that will enable the image pattern h to realize a reference solid density.
(2) The densities of patches c' and d' and of the patches e' and g' formed on the intermediate transfer belt 1203 are compared and the laser exposure is decided in such a manner that both densities will become the same. Here the test patch c' comprises only image data 0 (it is assumed that the laser exposure with regard to image data 0 has been decided separately) and 255, and the laser exposure has already been decided in the step above. Conversely, the test patch d' is formed only from image data 128. By comparing c' and d', therefore, it is possible to uniquely decide a laser exposure that corresponds to the image data 128.
   Further, the test patch e' also comprises only image data 0 and 255 and the laser exposure has already been decided in the step above. Conversely, the test patch g' is formed only from image data 128 and 0. By comparing e' and g', therefore, it is possible to uniquely decide a laser exposure that corresponds to the image data 128.
   It should be noted that in a case where the laser exposure corresponding to image data 128 obtained from the test patches c', d' and from e', g' differs, then the exposure is set to an intermediate value.
(3) The densities of patches e' and f' formed on the intermediate transfer belt 1203 are compared and the laser exposure corresponding to image data 64 is decided in such a manner that both densities will become the same. Here also the laser exposure with respect to image data 0, 255 corresponding to test patch e' has already been decided in a manner similar to that of the step above. Since the test patch f' is a pattern comprising image data 64 and 0, it is possible to uniquely decide a laser exposure corresponding to image data 64.
(4) The test patches a' and b' formed on the intermediate transfer belt 1203 are compared and a laser exposure corresponding to image data 192 is decided in such a manner that both densities will be the same. Here also laser exposure with respect to image data 0, 64, 255 corresponding to test patch b' has already been decided in a manner similar to that of the step above. Since the test patch a' is a pattern comprising image data 0 and 192, it is possible to uniquely decide a laser exposure corresponding to image data 192.
(5) Laser exposures corresponding to image data 0, 64, 128, 192, 255 are decided up to the foregoing step. In a case where it is necessary to decide laser exposures corresponding to image date other than these items of image data, these are set upon performing suitable interpolation and approximation, etc., based upon these values.

What becomes important in resolution is binary data (tone is not important, unlike the case of a grayscale image). When a resolution conversion is performed from 1200-dpi binary data to 600-dpi multivalued data using a 2 × 2 resolution conversion matrix, only 0, 64, 128, 192, 255 among the data 0 to 255 are used. That is, the first embodiment sets all multivalued outputs that appear in a case where resolution is converted from 1200-dpi binary data to 600-dpi multivalued data.

By setting an appropriate laser exposure through this process, it is possible to solve the above-described problem, namely that in a case where anti-aliasing processing using over-sampling is executed in an electrophotographic apparatus, a conversion is made to different image formation states after image patterns that are originally the same are subjected to a resolution conversion and, as a result, different image densities are output.

In accordance with the first embodiment, as described above, test patches of reference patterns are formed during non-image formation and the test patches are read on an intermediate transfer belt, thereby creating a laser-exposure correction table used in an area in which a resolution conversion was employed. In a case where anti-aliasing using over-sampling is executed by setting an appropriate exposure, it is possible to prevent a situation in which image patterns that are originally the same are converted to different image formation states after the resolution conversion, as a result of which the patterns are output at different image densities.

Further, according to the first embodiment, the laser-exposure correction table is created on the assumption that the coefficients of the matrix used in resolution conversion are fixed. However, this does not impose a limitation upon the invention and similar effects can be obtained by changing (e.g., increasing or decreasing) the coefficients of the resolution conversion matrix based upon the output results.

### [Second Embodiment]

A second embodiment of the present invention will now be described in detail with reference to the drawings.

The structure of the apparatus in the second embodiment is similar to that shown in Fig. 12 used in the first embodiment and need not be described again. The second embodiment is characterized in that the matrix used in the resolution conversion differs from that of the first embodiment. Specifically, use is made of a matrix in which 600-dpi boxes are shifted by one-half pixel with respect to 1200-dpi boxes, as illustrated in Fig. 16.

### <Resolution conversion>

In the second embodiment, the image data of character/vector portions expanded at 1200 dpi is converted to a resolution of 600 dpi by averaging using a matrix of the kind shown in Fig. 16 in the resolution converter 1211 in a manner similar to that of the first embodiment. Unlike the first embodiment, however, a resolution conversion is performed by executing averaging processing using a matrix in which 600-dpi boxes are shifted by one-half pixel with respect to 1200-dpi boxes. As a result, a slight difference occurs in line and character quality after the resolution conversion.

Fig. 17 is a diagram illustrating an example of resolution conversion according to the second embodiment. Fig. 17 shows a result l' obtained by subjecting a 1200-dpi 1-dot diagonal line to a resolution conversion according to the first embodiment, and a result 2' obtained by subjecting a 1200-dpi, 1-dot diagonal line to a resolution conversion according to the second embodiment. With the resolution conversion according to the first embodiment, four 1200-dpi pixels are included in a 2 × 2 matrix. Since there is no difference among the four pixels, information relating to a difference in the four pixels is lost after the resolution conversion. Conversely, when an attempt is made to output a pattern that fits within the 2 × 2 matrix, a 1200-dpi position resolution is not obtained. As a consequence, there are cases where the jaggies-suppression effect is not obtained, as at the portion indicated by the arrow in 1'.

By contrast, a resolution conversion according to the second embodiment is such that if a pattern is larger than a 1200-dpi, 1-dot pattern, resolution is always converted in a state in which the pattern spans a plurality of matrices. In other words, resolution is converted while maintaining the 1200-dpi position resolution as is. As a result, the jaggie-suppression effect will not be lost, as indicated at 2' in Fig. 17, even in the case of the aforementioned example, namely the 1200-dpi, 1-dot diagonal line.

### <Reference image formation, reading of reference image and correction of exposure>

In a manner similar to that of the first embodiment, eight types of test patches i', j', k', l', m', n', o' and h shown in Figs. 18 and 19 are formed. The densities of a test patches that have been formed on the intermediate transfer belt 1203 are measured by the density sensor 1206.

More specifically, a laser-exposure correction table of the kind shown in Fig. 20 is created through the procedure described below. Here the image data is handled as data having 256 levels of 0 to 255.
(1) The test patch h on the intermediate transfer belt 1203 is measured by the density sensor 1206 and a laser exposure corresponding to image data 255 that provides the highest density is set to an exposure that will enable the image pattern h to realize a reference solid density.
(2) A laser exposure corresponding to image data 64 [= 255 × (4/16)] is decided in such a manner that test patch i' formed on the intermediate transfer belt 1203 will distinctly become a dot image.
(3) The densities of patches i' and k' formed on the intermediate transfer belt 1203 are compared and the laser exposure for image data 32 [= 255 × (2/16)] is decided in such a manner that both densities will become the same. It should be noted that since the test patch i' has already been decided in the step above, it is possible to uniquely decide a laser exposure that corresponds to the image data 32.
(4) The densities of patches i' and j' formed on the intermediate transfer belt 1203 are compared and a laser exposure corresponding to image data 16 [= 255 × (1/16)] is decided in such a manner that both densities will become the same.
(5) The densities of patches 1' and m' formed on the intermediate transfer belt 1203 are compared and a laser exposure corresponding to image data 128 [= 255 × (8/16)] is decided in such a manner that both densities will become the same.
(6) The densities of patches n' and o' formed on the intermediate transfer belt 1203 are compared and a laser exposure corresponding to image data 192 [= 255 × (12/16)] is decided in such a manner that both densities will become the same.
(7) Laser exposures corresponding to image data 0, 16, 32, 64, 128, 192, 255 are decided up to the foregoing step. In a case where it is necessary to decide laser exposures corresponding to image date other than these items of image data, these are set upon performing suitable interpolation and approximation, etc., based upon these values.

By setting an appropriate laser exposure through this process according to the second embodiment, it is possible to solve the above-described problem, namely that in a case where anti-aliasing processing using over-sampling is executed in an electrophotographic apparatus, a conversion is made to different image formation states after image patterns that are originally the same are subjected to a resolution conversion and, as a result, different image densities are output. At the same time, owing to the fact that 1200-dpi boxes and 600-dpi boxes, which are the result of a resolution conversion, have been shifted by a half pixel of 1200-dpi pixels, it is possible to perform a resolution conversion while maintaining the 1200-dpi position resolution as is. In addition, a more stable, high-quality output can be obtained.

Further, according to the second embodiment, as in the first embodiment, the laser-exposure correction table is created on the assumption that the coefficients of the matrix used in resolution conversion are fixed. However, this does not impose a limitation upon the invention and similar effects can be obtained by changing (e.g., increasing or decreasing) the coefficients of the resolution conversion matrix based upon the output results.

### [Third Embodiment]

A third embodiment of the present invention will now be described in detail with reference to the drawings.

The structure of the apparatus in the third embodiment is similar to that shown in Fig. 12 used in the first and second embodiments and need not be described again. The third embodiment is characterized in that the matrix used in the resolution conversion differs from those of the first and second embodiments. Specifically, use is made of a 4 × 4 matrix with respect to 1200 dpi, as shown in Fig. 21. A further characteristic of the third embodiment is that a plurality of test patterns are output and the amount of laser exposure is set by measuring position rather than density at the time of measurement.

### <Resolution conversion>

Fig. 21 is a diagram illustrating a matrix used in a resolution conversion according to the third embodiment. The matrix used in the third embodiment is a 4 × 4 matrix. If a matrix with regard to all 600-dpi pixels were to be displayed, identification in the drawing would be difficult. Accordingly, here only one matrix is displayed among four pixels of 600 dpi.

According to the third embodiment, averaging processing is executed by a 4 × 4 matrix of the kind shown in Fig. 21 when a resolution conversion is made from 1200 dpi to 600 dpi. Therefore, each dot of 1200 dpi is decomposed always under identical conditions into four peripheral points always at 600 dpi and the image formation states are forced to be equal at any of the points. What is different is only the intensity balance among the four points. When a comparison is made with the matrices used in the first and second embodiments, therefore, it is possible to perform an output of image patterns under comparatively similar conditions in various patterns.

However, since the dots of 1200 dpi are distributed while the four peripheral dots are weighted, the position of the center of gravity of the dots output changes depending upon the intensity of weighting. For example, in case of a 1-dot, 6-space line pattern at 1200 dpi shown in Fig. 22, it will be understood that weighting balance in the horizontal direction changes every other line. If such a pattern is output, a problem which arises is that line spacing changes every other line unless an appropriate exposure correction is applied. In the case of the example shown in Fig. 22, a difference in length develops between line-to-line spacing A and line-to-line spacing B.

In order to solve this problem, the third embodiment is characterized in that test patches of reference patterns are formed during non-image formation, and a laser-exposure correction table is created in such a manner that the centroid balance of the output image will not be lost.

### <Reference image formation, reading of reference image and correction of exposure>

In the third embodiment, a pattern A in which an A portion is repeated at fixed intervals from a pattern p' shown in Fig. 22 and a portion B in which a B portion is repeated at fixed intervals are formed during non-image formation. In electrophotography, density rises in a case where the spacing between two lines diminishes. If the line spacing differs between the patterns A and B, therefore, this is detected as a difference in average densities between the patterns A and B. Accordingly, if it is so arranged that a difference in average densities will not occur between the patterns A and B, then the line spacing between the patterns A and B also will become equal.

Hence, according to the third embodiment, average densities between patterns A, B formed on the intermediate transfer belt 1203 are detected and the laser-exposure ratio with respect to image data 106 [= 255 × (2+3+3+2)/24] and image data 106 [= 255 × (1+2+2+1)/24] is set in such a manner that the two average densities will become the same.

Thus, the third embodiment solves the problem of the shift in output positions of lines or the like in an output image in a case where the anti-aliasing technique is used in electrophotography. Specifically, by outputting test patterns and setting an appropriate laser-exposure ratio, the centroid balance of the output image is prevented from being shifted non-uniformly and it is possible to produce a stable, high-quality output.

According to the third embodiment, as in the first and second embodiments, the laser-exposure correction table is created on the assumption that the coefficients of the matrix used in resolution conversion are fixed. However, this does not impose a limitation upon the invention and similar effects can be obtained by changing (e.g., increasing or decreasing) the coefficients of the resolution conversion matrix based upon the output results.

Further, the third embodiment is an alternative to measuring the line distance between patterns A and B based upon measurement of average densities between patterns A and B. However, this does not impose a limitation upon the invention and equivalent effects can of course be obtained by directly measuring output positions of lines and dots, etc.

As described above, in an electrophotographic apparatus for implementing anti-aliasing processing using over-sampling, patterns that take on different image formation states after a resolution conversion despite the fact that the image patterns are originally the same at the time of high-resolution development are formed as test patterns during non-image formation and the test patterns are measured, and a laser-exposure correction table used in an area in which a resolution conversion has been employed or a parameter used in a resolution conversion is decided so as to make identical the patterns that take on different image formation states after a resolution conversion despite the fact that the image patterns are originally the same at the time of high-resolution development. As a result, in a case where anti-aliasing processing used in over-sampling has been executed, it is possible to prevent, by appropriate control of exposure, a situation in which image patterns that are originally identical are converted to a different image formation state after a resolution conversion and, as a consequence, different image densities are output.

The present invention can be applied to a system constituted by a plurality of devices (e.g., a host computer, interface, reader, printer, etc.) or to an apparatus comprising a single device (e.g., a copier or facsimile machine, etc.).

Furthermore, it goes without saying that the object of the invention is attained also by supplying a recording medium storing the program codes of the software for performing the functions of the foregoing embodiments to a system or an apparatus, reading the program codes with a computer (e.g., a CPU or MPU) of the system or apparatus from the recording medium, and then executing the program codes.

In this case, the program codes read from the recording medium implement the novel functions of the embodiments and the recording medium storing the program codes constitutes the invention.

Examples of storage media that can be used for supplying the program code are a floppy disk (registered trademark), hard disk, optical disk, magneto-optical disk, CD-ROM, CD-R, magnetic tape, non-volatile type memory card or ROM, etc.

Furthermore, besides the case where the aforesaid functions according to the embodiments are implemented by executing the program codes read by a computer, it goes without saying that the present invention covers a case where an operating system or the like running on the computer performs a part of or the entire process in accordance with the designation of program codes and implements the functions according to the embodiments.

It goes without saying that the present invention further covers a case where, after the program codes read from the recording medium are written in a function expansion board inserted into the computer or in a memory provided in a function expansion unit connected to the computer, a CPU or the like contained in the function expansion board or function expansion unit performs a part of or the entire process in accordance with the designation of program codes and implements the function of the above embodiments.

Thus, in accordance with the embodiment of the invention as described above, amount of laser exposure based upon an electrophotographic process is set appropriately, thereby preventing non-uniformity of density and shape of an image and performing stable, high-quality image output.

As many apparently widely different embodiments of the present invention can be made without departing from the spirit and scope thereof, it is to be understood that the invention is not limited to the specific embodiments thereof except as defined in the appended claims.

## Claims

1. An exposure deciding method for deciding laser exposure when image formation is performed by an electrophotographic process, comprising:
an expansion step of expanding image data at a resolution higher that actual resolution of an output apparatus;
a resolution conversion step of subjecting high-resolution data, which is the result of expansion at said expansion step, to a resolution conversion to the actual resolution of the output apparatus;
an exposure decision step of deciding laser exposure when image formation is performed in such a manner that density of prescribed image data will be the same before and after image formation; and
an image formation step of forming an image represented by image data, which has undergone the resolution conversion performed at said resolution conversion step, based upon the laser exposure that has been decided at said exposure decision step.

2. The method according to claim 1, wherein said resolution conversion step includes averaging the high-resolution data using a matrix of a predetermined size and subjecting the actual resolution of the output apparatus to a resolution conversion.

3. The method according to claim 1, wherein said resolution conversion step includes averaging the high-resolution data using a matrix in which boxes of a matrix of a predetermined size have been shifted by one-half pixel.

4. The method according to claim 1, wherein said exposure decision step includes forming a prescribed pattern that will take on a different image formation state despite the fact that image pattern is the same originally, measuring the density of the prescribed pattern formed, and deciding the laser exposure in such a manner that the density of the prescribed pattern will be the same before and after image formation.

5. The method according to claim 1, wherein said exposure decision step includes forming a prescribed pattern that is repeated at fixed intervals, measuring the density of the prescribed pattern formed and deciding the laser exposure based upon the result of measurement in such a manner that a difference in average density will not develop between the prescribed patterns.

6. An image forming apparatus for deciding laser exposure when image formation is performed by an electrophotographic process, comprising:
expansion means for expanding image data at a resolution higher that actual resolution of an output apparatus;
resolution conversion means for subjecting high-resolution data, which is the result of expansion by said expansion means, to a resolution conversion to the actual resolution of the output apparatus;
exposure decision means for deciding laser exposure when image formation is performed in such a manner that density of prescribed image data will be the same before and after image formation; and
image formation means forming an image represented by image data, which has undergone the resolution conversion performed by said resolution conversion means, based upon the laser exposure that has been decided by said exposure decision means.

7. A program for causing a computer to execute the exposure deciding method set forth in claim 1.

8. A computer-readable recording medium storing the program set forth in claim 7.
